# EUROPEAN PATENT SPECIFICATION

(11) **EP 1 783 826 B1**
(45) Date of publication and mention of the grant of the patent: **30.11.2016**
(21) Application number: 05782096.1
(22) Date of filing: 08.09.2005
(51) Int. Cl.: H01L 21/337, H01L 29/808, H01L 29/80

(54) **JUNCTION FIELD-EFFECT TRANSISTOR**
VERBINDUNGS-FELDEFFEKTTRANSISTOR
TRANSISTOR À EFFET DE CHAMP À JONCTION

(30) Priority: 24.01.2005 JP 2005015395
(43) Date of publication of application: 09.05.2007
(73) Proprietor: Sumitomo Electric Industries, Ltd., Osaka-shi, Osaka 541-0041 (JP)
(72) Inventor: FUJIKAWA, Kazuhiro,, Osaka-shi, Osaka 5548511 (JP); HARADA, Shin, Osaka-shi, Osaka 5548511 (JP)
(74) Representative: Grünecker Patent- und Rechtsanwälte PartG mbB
(86) International application number: PCT/JP2005/016481
(87) International publication number: WO 2006/077674

(56) References cited:
- WO-A-2004/084310
- WO-A1-00/14809
- JP-A- 54 057 969
- JP-A- 2003 151 995
- US-A1- 2002 139 992
- US-A1- 2002 167 011

## Description

### Technical Field

The present invention relates to a junction field-effect transistor, and more specifically, it relates to a junction field-effect transistor capable of easily controlling the threshold voltage and capable of easily controlling a saturation current flowing in a channel region.

### Background Art

Silicon carbide (hereinafter abbreviated as SiC), having a wide band gap and a maximum insulation field larger by about one digit as compared with silicon (hereinafter abbreviated as Si), is a material expected for application to next-generation power semiconductor devices. SiC has heretofore been applied to various electronic devices through single-crystalline wafers referred to as 4H-SiC or 6H-SiC, and is regarded as suitable to high-temperature/high-power devices in particular. The aforementioned crystal is alpha-phase SiC formed by stacking zinc blende and wurtzite. Semiconductor devices have also been experimentally manufactured through a beta-phase SiC crystal referred to as 3C-SiC. A Schottky diode, a MOSFET (metal oxide semiconductor field-effect transistor), thyristor etc. serving as power devices or a CMOS (complementary mental-oxide semiconductor)-IC (integrated circuit), which is the most versatile semiconductor device, has recently been experimentally manufactured, and it has been confirmed from the characteristics thereof that the characteristics are extremely excellent as compared with conventional Si semiconductor devices.

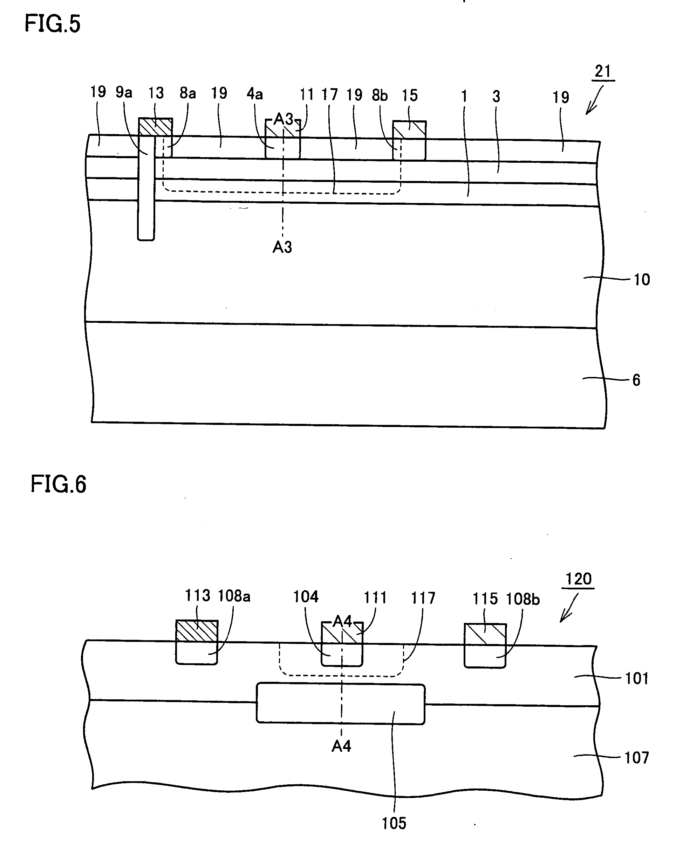

Fig. 6 is a sectional view showing the structure of a conventional junction field-effect transistor. As shown in Fig. 6, the conventional junction field-effect transistor 120 comprises a p-type semiconductor layer 107, an n-type semiconductor layer 101, a p⁺ buried layer 105, a p⁺ region 104, n⁺ regions 108a and 108b, a gate electrode 111, a source electrode 113 and a drain electrode 115.

The n-type semiconductor layer 101 is formed on the p-type semiconductor layer 107 by epitaxy, and the p⁺ buried layer 105 is formed on a deep position around the boundary between the p-type semiconductor layer 107 and the n-type semiconductor layer 101. The p⁺ region 104 and the n⁺ regions 108a and 108b are formed on the surface of the n-type semiconductor layer 101. The gate electrode 111, the source electrode 113 and the drain electrode 115 are formed on the surface of the n-type semiconductor layer 101. The gate electrode 111 and the p⁺ region 104 are electrically connected with each other, the source electrode 113 and the n⁺ region 108a are electrically connected with each other, and the drain electrode 115 and the n⁺ region 108b are electrically connected with each other.

In the junction field-effect transistor 120, the n-type semiconductor layer 101 located immediately under the p⁺ region 104 serves as a channel. In other words, a negative voltage is so applied to the gate electrode 111 that a depletion layer 117 spreads in the n-type semiconductor layer 101 from the boundary between the n-type semiconductor layer 101 and the p⁺ region 104 toward the boundary between the n-type semiconductor layer 101 and the p⁺ buried layer 105 and a current between the drain electrode 115 and the source electrode 113 is cut off in a case of a normally-on transistor. In a case of a normally-off transistor, a positive voltage is so applied to the gate electrode 111 that the depletion layer 117 shrinks in the n-type semiconductor layer 101 from the boundary between the n-type semiconductor layer 101 and the p⁺ buried layer 105 toward the boundary between the n-type semiconductor layer 101 and the p⁺ region 104 and a current flows between the drain electrode 115 and the source electrode 113. For example, Patent No. 3216804 (Japanese Patent Laying-Open No. 11-195655 (Patent Literature 1)) discloses a junction field-effect transistor similar to the aforementioned structure.

Patent Document 1: Patent No. 3216804 (Japanese Patent Laying-Open No. 11-195655)

US2002/0167011 discloses a junction field effect transistor.

### Disclosure of the Invention

### Problems to be Solved by the Invention

Referring to Fig. 6, an dopant diffusion rate in SiC is so extremely slow that it takes an extremely long time for diffusing dopants into the n-type semiconductor layer 101 in order to form the p⁺ region 104 and the p⁺ buried layer 105 by thermal diffusion, if the n-type semiconductor layer 101 is composed of SiC. Therefore, the p⁺ region 104 and the p⁺ buried layer 105 are generally formed by implanting dopant ions into the n-type semiconductor layer 101 (ion implantation). When ion implantation is employed, the implanted dopants have prescribed concentration profiles in the depth direction. Therefore, the number of electrons in the n-type semiconductor layer 101 is reduced due to action of the implanted dopant ions. This is now described.

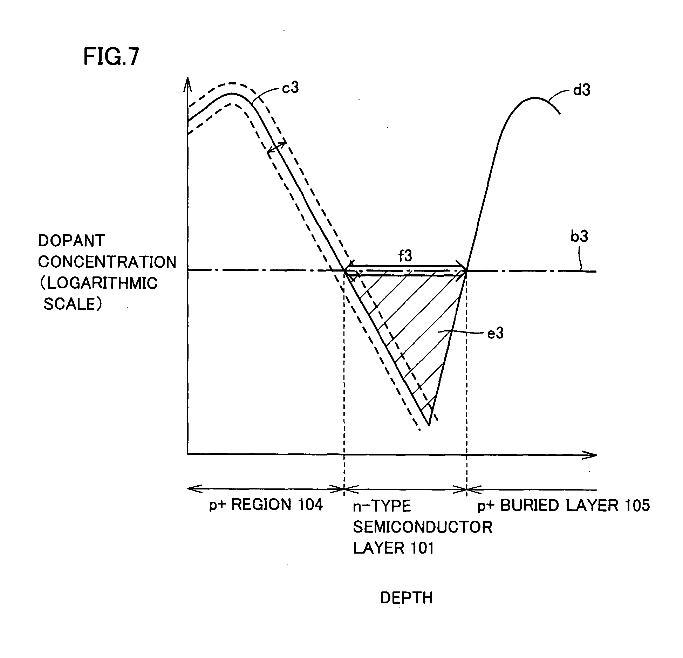

Fig. 7 schematically illustrates concentration profiles along the line A4-A4 in Fig. 6. Referring to Fig. 7, dopant ions implanted for forming the p⁺ region 104 have a concentration profile denoted by c3 in the depth direction. Similarly, dopant ions implanted for forming the p⁺ buried layer 105 have a concentration profile denoted by d3 in the depth direction. As obvious also from the concentration profile c3 of the dopant ions, the dopant ions implanted for forming the p⁺ region 104 partially reach a region for forming the n-type semiconductor layer 101 without remaining in a region for forming the p⁺ region 104. When the dopant ions reach the region for forming the n-type semiconductor layer 101, minority carriers (holes) resulting from the dopants and majority carriers (electrons) present in the n-type semiconductor layer 101 recombine with each other, to reduce the number of the majority carriers present in the n-type semiconductor layer 101. Similarly, the dopant ions implanted for forming the p⁺ buried layer 105 partially remain in the region for forming the n-type semiconductor layer 101 without reaching a region for forming the p⁺ buried layer 105, as obvious also from the concentration profile d3 of the dopant ions. Thus, the dopant ions reduce the number of electrons present in the n-type semiconductor layer 101.

When the concentration of electrons originally present in the n-type semiconductor layer 101 is expressed by a one-dot chain line b3 in Fig. 7, the concentration of electrons actually present in the n-type semiconductor layer 101 is expressed by the difference between the concentration b3 of the electrons originally present in the n-type semiconductor layer 101 and the concentration profiles c3 and d3 of the dopant ions, i.e., the area of a region e3. Since the axis of ordinates in Fig. 7 is on a logarithmic scale, the concentration of the electrons actually present in the n-type semiconductor layer 101 is approximately expressed by the length f3 of the uppermost portion in the region e3.

Ion implantation has such a disadvantage that it is difficult to control concentration profiles of dopant ions in the depth direction. Therefore, the concentration profile c3 of the dopant ions is dispersable in the depth direction, as shown by dotted lines in Fig. 7 (similarly, the concentration profile d3 of the dopant ions is also dispersable in the depth direction, while this is not illustrated). When the concentration profile c3 of the dopant ions is dispersed in the depth direction, the number of dopant ions reaching the n-type semiconductor layer 101 changes to influence the decrement of the electron concentration f3 (e3).

More specifically, the concentration profile c3 slides to the left dotted line in the figure and the electron concentration f3 (e3) exceeds the design value when the dopant ions are implanted into a region shallower than the design value. When the dopant ions are implanted into a region deeper than the design value, on the other hand, the concentration profile c3 slides to the right dotted line in the figure, and the electron concentration f3 (e3) falls below the design value.

Since the n-type semiconductor layer 101 is a portion serving as the channel of the junction field-effect transistor 120 as hereinabove described, the aforementioned change of the electron concentration f3 (e3) influences the threshold voltage of the transistor and the saturation current density of the channel. Therefore, there has been such a problem in the conventional junction field-effect transistor that the threshold voltage and the saturation current density of the channel are hard to control.

This problem is not a problem caused only in a junction field-effect transistor employing SiC but a problem caused in general junction field-effect transistors. In the case of SiC, however, the dopant concentration profile tends to increase (tends to tail) in a deep portion, and hence this problem is particularly important.

Accordingly, an object of the present invention is to provide a junction field-effect transistor capable of easily controlling the threshold voltage and capable of easily controlling saturation current density of a channel.

### Means for Solving the Problems

The junction field-effect transistor according to the present invention comprises a transistor according to claim 1.

According to the inventive junction field-effect transistor, relatively high-concentration dopant ions are implanted into the buffer layer in formation of the second conductivity-type doped region. However, the number of first conductivity type carriers present in the buffer layer is originally small, whereby the number of the carriers hardly decreases in the buffer layer. Further, relatively low-concentration dopant ions are implanted into the first conductivity type semiconductor layer, whereby the number of first conductivity type carriers in the first conductivity type semiconductor layer hardly decreases. In other words, the concentration of the first conductivity type carriers present in the channel region is hardly influenced in formation of the second conductivity type doped region. Also when the concentration profile of second conductivity type dopant ions is dispersed in the depth direction in formation of the second conductivity type doped region, therefore, the concentration of the first conductivity type carriers present in the channel region is hardly influenced. Consequently, the threshold voltage can be easily controlled, and the saturation current of the channel can be easily controlled.

Preferably in the junction field-effect transistor according to the present invention, the first conductivity type carrier concentration in the buffer layer is not more than one tenth of the first conductivity type carrier concentration in the first conductivity type semiconductor layer.

Thus, the number of carriers present in the buffer layer is sufficiently reduced as compared with the number of carriers present in the first conductivity type semiconductor layer, whereby the number of carriers reduced by dopant implantation decreases to an ignorable extent.

Preferably in the junction field-effect transistor according to the present invention, the first conductivity type semiconductor layer is composed of SiC.

SiC, having a wide band gap and a maximum insulation field larger by about one digit as compared with Si, is suitable as the material for the junction field-effect transistor. In ion implantation into SiC, further, the quantity of dopant implantation is particularly dispersable in the depth direction. Therefore, the structure of the present invention is particularly effective.

Preferably, the junction field-effect transistor according to the present invention further comprises a second conductivity type semiconductor layer formed under the channel region.

Thus, it is possible to feed no current to the channel region by extending a depletion layer on the boundary between the first conductivity type semiconductor layer and the second conductivity type doped region toward the second conductivity type semiconductor layer.

Preferably in the junction field-effect transistor according to the present invention, the second conductivity type semiconductor layer is formed by implanting an dopant, and the junction field-effect transistor further comprises another buffer layer formed under the channel region on the second conductivity type semiconductor layer. A first conductivity type carrier concentration in another buffer layer is lower than the first conductivity type carrier concentration in the first conductivity type semiconductor layer.

Thus, relatively high-concentration dopant ions are implanted into another buffer layer in formation of the second conductivity type semiconductor layer. However, the number of first conductivity type carriers present in another buffer layer is originally small, whereby the number of carriers hardly decreases in another buffer layer. Further, relatively low-concentration dopant ions are implanted into the first conductivity type semiconductor layer, whereby the number of first conductivity type carriers in the first conductivity type semiconductor layer hardly decreases. In other words, the concentration of the first conductivity type carriers present in the channel region is hardly influenced in formation of the second conductivity type semiconductor layer. Also when the concentration profile of second conductivity type dopant ions is dispersed in the depth direction in formation of the second conductivity type semiconductor layer, therefore, the concentration of the first conductivity type carriers present in the first conductivity type semiconductor layer is hardly influenced. Consequently, control of the threshold voltage is simplified, and the saturation current of the channel can be controlled.

Preferably in the junction field-effect transistor according to the present invention, the first conductivity type carrier concentration in the aforementioned another buffer layer is not more than one tenth of the first conductivity type carrier concentration in the first conductivity type semiconductor layer.

Thus, the number of carriers present in another buffer layer is sufficiently reduced as compared with the number of carriers present in the first conductivity type semiconductor layer, whereby the number of carriers reduced by dopant implantation decreases to an ignorable extent.

Preferably, the junction field-effect transistor according to the present invention further comprises a semiconductor substrate composed of n-type SiC. The first conductivity type semiconductor layer is formed on one main surface of this semiconductor substrate.

A semiconductor substrate composed of n-type SiC has lower density of defects such as micropipes (through dislocations) as compared with a semiconductor substrate composed of p-type SiC. Therefore, the yield can be improved, and a leakage current can be reduced.

Preferably, the junction field-effect transistor according to the present invention further comprises a gate electrode formed on the surface of the second conductivity type doped region, an electrode, either a source electrode or a drain electrode, formed on the surface of the first conductivity type semiconductor layer and another electrode, either a drain electrode or a source electrode, formed on another main surface of the semiconductor substrate.

Thus, carriers move substantially perpendicularly to the semiconductor substrate, to form the so-called vertical field-effect transistor.

Preferably, the junction field-effect transistor according to the present invention further comprises a gate electrode formed on the surface of the second conductivity type doped region, and a source electrode and a drain electrode formed on the surface of the first conductivity type semiconductor layer.

Thus, carriers move substantially parallelly to the semiconductor substrate, to form the so-called horizontal field-effect transistor.

### Effects of the Invention

According to the inventive junction field-effect transistor, the threshold voltage can be easily controlled, and the saturation current density of the channel can be easily controlled.

### Brief Description of the Drawings

Fig. 1 is a sectional view showing the structure of a junction field-effect transistor according to a first embodiment of the present invention.
Fig. 2 is a diagram schematically showing concentration profiles along the line A1-A1 in Fig. 1.
Fig. 3 is a sectional view showing the structure of a junction field-effect transistor according to a second embodiment of the present invention.
Fig. 4 is a diagram schematically showing concentration profiles along the line A2-A2 in Fig. 3.
Fig. 5 is a sectional view showing the structure of a junction field-effect transistor according to a third embodiment of the present invention.
Fig. 6 is a sectional view showing the structure of a conventional junction field-effect transistor.
Fig. 7 is a diagram schematically showing concentration profiles along the line A4-A4 in Fig. 6.

### Description of the Reference Signs

1 semiconductor layer, 3, 18 buffer layer, 4a, 4b, 9a, 9b, 104 p⁺ region, 5a, 5b, 105 p⁺ buried layer, 6 semiconductor substrate, 6a, 6b substrate main surface, 7 n-type epitaxial layer, 8a, 8b, 108a, 108b n⁺ region, 10 p-type epitaxial layer, 11, 11a, 11b, 111 gate electrode, 13, 13a, 13b, 113 source electrode, 15, 115 drain electrode, 17, 17a, 17b, 117 depletion layer, 19 p-type region, 20, 20a, 21, 120 junction field-effect transistor, 101 n-type semiconductor layer, 107 p-type semiconductor layer.

### Best Modes for Carrying Out the Invention

Embodiments of the present invention are now described with reference to the drawings.

### (First Embodiment)

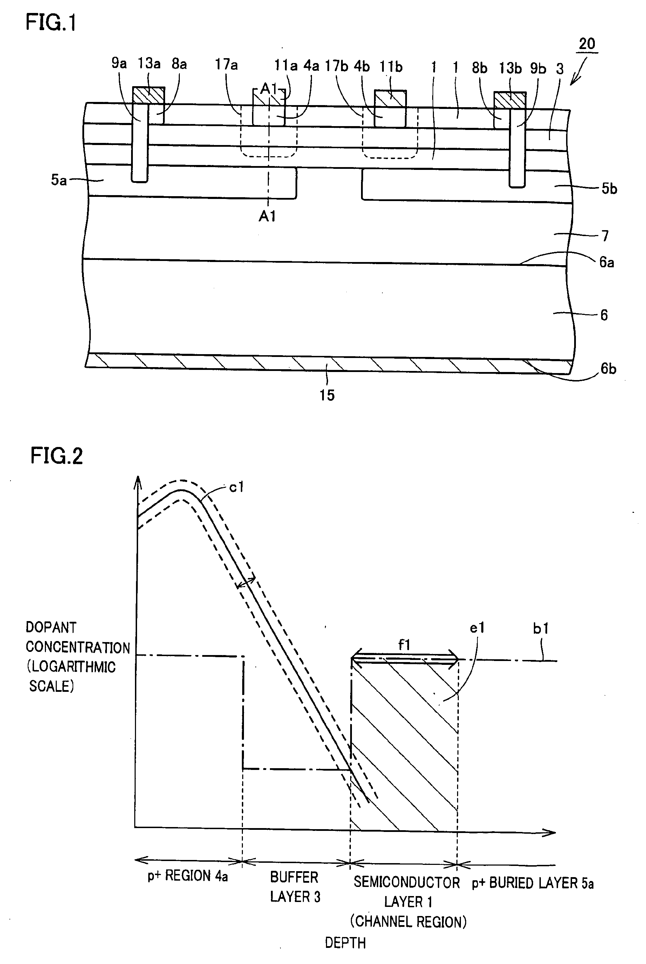

Fig. 1 is a sectional view showing the structure of a junction field-effect transistor according to a first embodiment of the present invention. As shown in Fig. 1, the junction field-effect transistor 20 according to this embodiment comprises a semiconductor substrate 6, an n-type epitaxial layer 7, an n-type semiconductor layer 1 as a first conductivity type semiconductor layer, a buffer layer 3, p⁺ buried layers 5a and 5b as second conductivity type semiconductor layers, p⁺ regions 4a and 4b as second conductivity type doped regions, n⁺ regions 8a and 8b, p⁺ regions 9a and 9b, gate electrodes 11a and 11b, source electrodes 13a and 13b and a drain electrode 15.

The n-type epitaxial layer 7 is formed on one main surface 6a of the semiconductor substrate 6 composed of n-type SiC, and the p⁺ buried layers 5a and 5b are formed on the surface of the n-type epitaxial layer 7. The semiconductor layer 1 is formed on the n-type epitaxial layer 7 and the p⁺ buried layers 5a and 5b. The p⁺ regions 4a and 4b, the n⁺ regions 8a and 8b and the p⁺ regions 9a and 9b are formed on the surface of the semiconductor layer 1. The n⁺ region 8 a and the p⁺ region 9a are formed adjacently to each other, and the n⁺ region 8b and the p⁺ region 9b are formed adjacently to each other. The respective ones of the p⁺ regions 4a and 4b are formed by implanting dopant ions. The respective ones of the p⁺ regions 9a and 9b extend downward in the figure, and reach the respective ones of the p⁺ buried layers 5a and 5b.

The semiconductor layer 1 is composed of SiC. In the semiconductor layer 1, regions around those located vertically immediately under the respective ones of the p⁺ regions 4a and 4b are channel regions of the junction field-effect transistor 120. The channel regions are formed on the p⁺ buried layers 5a and 5b.

The buffer layer 3 is formed in the semiconductor layer 1. The buffer layer 3 is formed on the channel regions under the p⁺ regions 4a and 4b. The electron concentration in the buffer layer 3 is lower than the electron concentration in the semiconductor layer 1, and the electron concentration in the buffer layer 3 is not more than one tenth of the electron concentration in the semiconductor layer 1. The buffer layer 3 may be an n⁻ region, may be an undoped layer, or may be a p⁻ region.

The gate electrodes 11a and 11b are formed on the surfaces of the respective ones of the p⁺ regions 4a and 4b. Further, the source electrode 13a is formed on the surfaces of the n⁺ region 8a and the p⁺ region 9a, and the source electrode 13b is formed on the surfaces of the n⁺ region 8b and the p⁺ region 9b (the surface of the semiconductor layer 1). The drain electrode 15 is formed on another main surface 6b (lower side in the figure) of the semiconductor substrate 6.

When the junction field-effect transistor 20 is a normally-on transistor, a negative voltage is so applied to the gate electrodes 11a and 11b that the respective ones of depletion layers 17a and 17b spread in the channel regions, and currents between the drain electrode 15 and the respective ones of the source electrodes 13a and 13b are cut off. When the junction field-effect transistor 20 is a normally-off transistor, a positive voltage is so applied to the gate electrodes 11a and 11b that the respective ones of the depletion layers 17a and 17b disappear from the channel regions and currents flow between the drain electrode 15 and the source electrodes 13 a and 13b through the channel regions.

According to the junction field-effect transistor 20 of this embodiment, the concentrations of electrons present in the channel regions are hardly influenced in formation of the p⁺ regions 4a and 4b. This is now described.

Fig. 2 is a diagram schematically showing concentration profiles along the line A1-A1 in Fig. 1. Referring to Fig. 2, dopant ions implanted for forming the p⁺ region 4a have a concentration profile denoted by c1 in the depth direction. A one-dot chain line b1 denotes the concentration profile of carriers (electrons) originally present in the buffer layer 3 and the semiconductor layer 1. The concentration of electrons actually present in the semiconductor layer 1 is expressed by the difference between the concentration b1 of electrons originally present in the semiconductor layer 1 (present in the semiconductor layer 1 not yet formed with the doped region therein) and the concentration profile c1 of the dopant ions, i.e., the area of a region e1. Since the axis of ordinates in Fig. 2 is on a logarithmic scale, the concentration of the electrons actually present in the semiconductor layer 1 is approximately expressed by the length f1 of the uppermost portion in the region e1.

According to the concentration profile c1 of the dopant ions, the concentration of dopant ions present in the semiconductor layer 1 is extremely low as compared with the concentration b 1 of electrons originally present in the semiconductor layer 1, and the concentration f1 (e1) of electrons actually present in the semiconductor layer 1 is substantially equivalent to the concentration b 1 of electrons originally present in the semiconductor layer 1. Therefore, the concentrations of electrons present in the channel regions are hardly influenced in formation of the p⁺ region 4a. Since the number of electrons present in the buffer layer 3 is small as compared with the number of electrons present in the semiconductor layer 1, fluctuation of the number of electrons present in the buffer layer 3 is also small.

Also when the concentration profile c1 of p-type dopant ions is dispersed in the depth direction as shown by dotted lines in the figure in formation of the p⁺ regions 4a and 4b, therefore, the concentrations of electrons present in the channel regions are hardly influenced. Consequently, the threshold voltage can be easily controlled, and saturation currents of channels can be easily controlled.

In the junction field-effect transistor 20 according to this embodiment, the electron concentration in the buffer layer 3 is not more than one tenth of the electron concentration in the semiconductor layer 1.

Thus, the number of electrons present in the buffer layer 3 is sufficiently reduced as compared with the number of electrons present in the semiconductor layer 1, whereby the number of electrons reduced by dopant implantation decreases to an ignorable extent.

In the junction field-effect transistor 20 according to this embodiment, the semiconductor layer 1 is composed of SiC.

SiC, having a wide band gap and a maximum insulation field larger by about one digit as compared with Si, is suitable as the material for the junction field-effect transistor. In ion implantation into SiC, further, the quantity of dopant implantation is particularly dispersable in the depth direction. Therefore, the structure of the present invention is particularly effective.

The junction field-effect transistor 20 according to this embodiment further comprises the p⁺ buried layers 5a and 5b formed under the channel regions.

Thus, it is possible to feed no currents to the channel regions by extending the depletion layers 17a and 17b on the boundaries between the semiconductor layer 1 and the p⁺ regions 4a and 4b toward the p⁺ buried layers 5a and 5b.

The junction field-effect transistor 20 according to this embodiment further comprises the semiconductor substrate 6 composed of n-type SiC. The semiconductor layer 1 is formed on one main surface 6a of the semiconductor substrate 6.

A semiconductor substrate composed of n-type SiC has lower density of defects such as micropipes (through dislocations) as compared with a semiconductor substrate composed of p-type SiC. Therefore, the yield can be improved, and a leakage current can be reduced.

The junction field-effect transistor 20 according to this embodiment further comprises the gate electrodes 11a and 11b formed on the surfaces of the respective ones of the p⁺ regions 4a and 4b, the source electrodes 13a and 13b formed on the surface of the semiconductor layer 1, and the drain electrode 15 formed on another main surface 6b of the semiconductor substrate 6.

Thus, carriers move substantially perpendicularly to the semiconductor substrate 6, to form the so-called vertical field-effect transistor.

### (Second Embodiment)

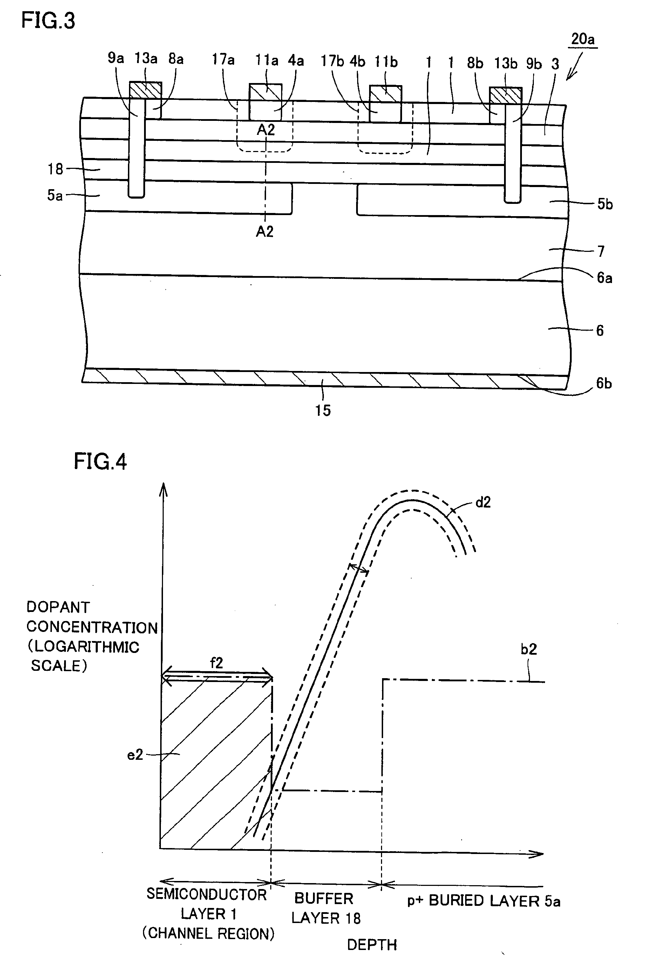

Fig. 3 is a sectional view showing the structure of a junction field-effect transistor according to a second embodiment of the present invention. As shown in Fig. 3, the junction field-effect transistor 20a according to this embodiment further comprises a buffer layer 18 as another buffer layer. The buffer layer 18 is formed under channel regions of a semiconductor layer 1 on p⁺ buried layers 5a and 5b. The electron concentration in the buffer layer 18 is lower than the electron concentration in the semiconductor layer 1. The electron concentration in the buffer layer 18 is not more than one tenth of the electron concentration in the semiconductor layer 1. Further, the respective ones of the p⁺ buried layers 5a and 5b are formed by implanting dopant ions.

The remaining structure of the junction field-effect transistor 20a is substantially similar to the structure of the junction field-effect transistor 20 shown in the first embodiment, and hence identical members are denoted by identical reference numerals, and description thereof is skipped.

According to the junction field-effect transistor 20a of this embodiment, the concentrations of electrons present in the channel regions are hardly influenced in formation of the p⁺ buried layers 5a and 5b. This is now described.

Fig. 4 is a diagram schematically showing concentration profiles along the line A2-A2 in Fig. 3. Referring to Fig. 4, dopant ions implanted for forming the p⁺ buried layer 5a have a concentration profile denoted by d2 in the depth direction. A one-dot chain line b2 denotes the concentration profile of electrons originally present in the buffer layer 18 and the semiconductor layer 1. The concentration of electrons actually present in the semiconductor layer 1 is expressed by the difference between the concentration b2 of electrons originally present in the semiconductor layer 1 and the concentration profile d2 of the dopant ions, i.e., the area of a region e2. Since the axis of ordinates in Fig. 4 is on a logarithmic scale, the concentration of the electrons actually present in the semiconductor layer 1 is approximately expressed by the length f2 of the uppermost portion in the region e2.

According to the concentration profile d2 of the dopant ions, the concentration of dopant ions present in the semiconductor layer 1 is extremely low as compared with the concentration b2 of electrons originally present in the semiconductor layer 1, and the concentration f2 (e2) of electrons actually present in the semiconductor layer 1 is substantially equivalent to the concentration b2 of electrons originally present in the semiconductor layer 1. Therefore, the concentrations of electrons present in the channel regions are hardly influenced in formation of the p⁺ buried layer 5a. Since the number of electrons present in the buffer layer 18 is small as compared with the number of electrons present in the semiconductor layer 1, fluctuation of the number of electrons present in the buffer layer 18 is also small.

Also when the concentration profile d2 of p-type dopant ions is dispersed in the depth direction as shown by dotted lines in the figure in formation of the p⁺ buried layers 5a and 5b, therefore, the concentrations of electrons present in the channel regions are hardly influenced. Consequently, the threshold voltage can be easily controlled, and saturation currents of channels can be easily controlled.

In the junction field-effect transistor 20a according to this embodiment, the electron concentration in the buffer layer 18 is not more than one tenth of the electron concentration in the semiconductor layer 1.

Thus, the number of electrons present in the buffer layer 18 is sufficiently reduced as compared with the number of electrons present in the semiconductor layer 1, whereby the number of electrons reduced by dopant implantation decreases to an ignorable extent.

### (Third Embodiment)

Fig. 5 is a sectional view showing the structure of a junction field-effect transistor according to a third embodiment of the present invention. As shown in Fig. 5, the junction field-effect transistor 21 according to this embodiment has a RESURF (reduced surface) structure, and is different from the junction field-effect transistor 20 according to the first embodiment in the following points:
In other words, a p-type epitaxial layer 10 is formed on a semiconductor substrate 6, and a semiconductor layer 1 is formed on the p-type epitaxial layer 10. A p-type region 19 is formed on the surface of the semiconductor layer 1, and a buffer layer 3 is formed in the semiconductor layer 1. P⁺ regions 4a and 9a and n⁺ regions 8a and 8b are formed on the surface of the p-type region 19. The p⁺ region 9a reaches the p-type epitaxial layer 10. A gate electrode 11 is formed on the surface of the p⁺ region 4a, a source electrode 13 is formed on the surfaces of the p⁺ region 9a and the n⁺ region 8a (the semiconductor layer 1), and a drain electrode 15 is formed on the surface of the n⁺ region 8b. Concentration profiles along the line A3-A3 in Fig. 5 are similar to the concentration profiles shown in Fig. 2. According to this embodiment, a region around that located vertically immediately under the p⁺ region 4a is a channel region of the junction field-effect transistor 21.

When the junction field-effect transistor 21 is a normally-on transistor, a negative voltage is so applied to the gate electrode 11 that a depletion layer 17 spreads in the channel region, and a current between the drain electrode 15 and the source electrode 13 is cut off. When the junction field-effect transistor 21 is a normally-off transistor, a positive voltage is so applied to the gate electrode 11 that each of the depletion layer 17 disappears from the channel region and a current flows between the drain electrode 15 and the source electrode 13 through the channel region.

The remaining structure is substantially similar to the structure of the junction field-effect transistor 20 shown in the first embodiment, and hence identical members are denoted by identical reference numerals, and description thereof is skipped.

Also in the junction field-effect transistor 21 according to this embodiment, effects similar to those of the junction field-effect transistor 20 shown in the first embodiment can be attained.

The junction field-effect transistor 21 according to this embodiment further comprises the gate electrode 11 formed on the surface of the p⁺ region 4a as well as the source electrode 13 and the drain electrode 15 formed on the surface of the semiconductor layer 1.

Thus, carriers move substantially parallelly to the semiconductor substrate 6, to form the so-called horizontal junction field-effect transistor.

It is possible to widen a depletion layer between a gate and a drain by forming the p-type region 19 on the semiconductor layer 1, as in this embodiment. Thus, the withstand voltage between the gate and the drain can be improved. The p-type region 19 in this embodiment is not an essential component, but the p⁺ regions 4a and 9a and the n⁺ regions 8a and 8b may be formed on the surface of the semiconductor layer 1 without forming the p-type region 19.

The embodiments disclosed in the above must be considered as illustrative in all points and not restricted. The scope of the present invention is shown not by the aforementioned embodiments but by the scope of claim for patent, and intended to include all corrections and modifications within the meaning and range equivalent to the scope of claim for patent.

## Claims

1. A junction field effect transistor (20) comprising in the following order:
a second conductivity type semiconductor layer (5a, 5b);
a first conductivity type semiconductor layer (1) having a plurality of channel regions;
a buffer layer (3) formed in said semiconductor type layer (1) and on said channel regions; and
a plurality of second conductivity type doped regions (4a, 4b) formed on said buffer layer (3) and located above said channel regions;
wherein a first conductivity type carrier concentration in said buffer layer (3) is lower than a first conductivity type carrier concentration in said first conductivity type semiconductor layer (1).

2. The junction field effect transistor (20) according to claim 1, wherein said first conductivity type carrier concentration in said buffer layer (3) is not more than one tenth of said first conductivity type carrier concentration in said first conductivity type semiconductor layer (1).

3. The junction field-effect transistor (20) according to claim 1, wherein said first conductivity type semiconductor layer (1) is composed of silicon carbide.

4. The junction field-effect transistor (20a) according to claim 1, wherein said second conductivity type semiconductor layer (5a, 5b) is formed by implanting dopant ions,
the junction field-effect transistor further comprises another buffer layer (18) formed under said channel region on said second conductivity type semiconductor layer,
a first conductivity type carrier concentration in said another buffer layer (18) is lower than the first conductivity type carrier concentration in said first conductivity type semiconductor layer (1).

5. The junction field-effect transistor (20a) according to claim 4, wherein said first conductivity type carrier concentration in said another buffer layer (18) is not more than one tenth of said first conductivity type carrier concentration in said first conductivity type semiconductor layer (1).

6. The junction field-effect transistor (20) according to claim 1, further comprising a semiconductor substrate (6) composed of n-type silicon carbide, wherein
said first conductivity type semiconductor layer (1) is formed on one main surface of said semiconductor substrate (6).

7. The junction field-effect transistor (21) according to claim 6, further comprising:
a gate electrode (11 a, 11 b) formed on the surface of said second conductivity type doped region (4a, 4b),
an electrode (13a, 13b), either a source electrode or a drain electrode, formed on the surface of said first conductivity type semiconductor layer (1), and
another electrode (15), either a drain electrode or a source electrode, formed on another main surface of said semiconductor substrate (6).

## Patentansprüche

1. Sperrschicht-Feldeffekt-Transistor (20), der in der folgenden Reihenfolge umfasst:
eine Halbleiterschicht (5a, 5b) mit einer zweiten Leitfähigkeit;
eine Halbleiterschicht (1) mit einer ersten Leitfähigkeit, die eine Vielzahl von Kanalbereichen aufweist;
eine Pufferschicht (3), die in der Halbleiterschicht (1) und auf den Kanalbereichen gebildet ist; und
eine Vielzahl von dotierten Gebieten (4a, 4b) mit einer zweiten Leitfähigkeit, die auf der Pufferschicht (3) gebildet und oberhalb der Kanalbereiche angeordnet sind;
wobei eine Ladungsträgerkonzentration mit einer ersten Leitfähigkeit in der Pufferschicht (3) niedriger als eine Ladungsträgerkonzentration mit einer ersten Leitfähigkeit in der Halbleiterschicht (1) mit der ersten Leitfähigkeit ist.

2. Sperrschicht-Feldeffekt-Transistor (20) nach Anspruch 1, wobei die Ladungsträgerkonzentration mit der ersten Leitfähigkeit in der Pufferschicht (3) nicht mehr als ein Zehntel der Ladungsträgerkonzentration mit der ersten Leitfähigkeit in der Halbleiterschicht (1) mit der ersten Leitfähigkeit beträgt.

3. Sperrschicht-Feldeffekt-Transistor (20) nach Anspruch 1, wobei die Halbleiterschicht (1) mit der ersten Leitfähigkeit aus Siliziumkarbid gebildet ist.

4. Sperrschicht-Feldeffekt-Transistor (20a) nach Anspruch 1, wobei die Halbleiterschicht (5a, 5b) mit der zweiten Leitfähigkeit durch Implantieren von Dotierstoff-Ionen gebildet ist,
der Sperrschicht-Feldeffekt-Transistor ferner eine weitere Pufferschicht (18) umfasst, die unter dem Kanalbereich auf der Halbleiterschicht mit der zweiten Leitfähigkeit gebildet ist,
eine Ladungsträgerkonzentration mit der ersten Leitfähigkeit in der weiteren Pufferschicht (18) niedriger als die Ladungsträgerkonzentration mit der ersten Leitfähigkeit in der Halbleiterschicht (1) mit der ersten Leitfähigkeit ist.

5. Sperrschicht-Feldeffekt-Transistor (20a) nach Anspruch 4, wobei die Ladungsträgerkonzentration mit der ersten Leitfähigkeit in der weiteren Pufferschicht (18) nicht mehr als ein Zehntel der Ladungsträgerkonzentration mit der ersten Leitfähigkeit in der Halbleiterschicht (1) mit der ersten Leitfähigkeit beträgt.

6. Sperrschicht-Feldeffekt-Transistor (20) nach Anspruch 1, der ferner ein Halbleitersubstrat (6), das aus n-Siliziumkarbid gebildet ist, umfasst, wobei
die Halbleiterschicht (1) mit der ersten Leitfähigkeit auf einer Hauptfläche des Halbleitersubstrats (6) gebildet ist.

7. Sperrschicht-Feldeffekt-Transistor (21) nach Anspruch 6, ferner umfassend:
eine Gate-Elektrode (11 a, 11 b), die auf der Oberfläche des dotierten Bereichs (4a, 4b) mit der zweiten Leitfähigkeit gebildet ist,
eine Elektrode (13a, 13b) in Form einer Source-Elektrode oder einer Drain-Elektrode, die auf der Oberfläche der Halbleiterschicht (1) mit der ersten Leitfähigkeit gebildet ist, und
eine weitere Elektrode (15) in Form einer Source-Elektrode oder einer Drain-Elektrode, die auf einer weiteren Hauptfläche des Halbleitersubstrats (6) gebildet ist.

## Revendications

1. Transistor à effet de champ à jonction (20) comprenant dans l'ordre suivant :
une couche semi-conductrice d'un second type de conductivité (5a, 5b) ;
une couche semi-conductrice d'un premier type de conductivité (1) présentant une pluralité de régions de canal ;
une couche tampon (3) formée dans ladite couche de type semi-conductrice (1) et
sur lesdites régions de canal ; et
une pluralité de régions dopées d'un second type de conductivité (4a, 4b) formées sur ladite couche tampon (3) et situées au-dessus desdites régions de canal ;
où une concentration en porteurs d'un premier type de conductivité dans ladite couche tampon (3) est inférieure à une concentration en porteurs d'un premier type de conductivité dans ladite couche semi-conductrice d'un premier type de conductivité (1).

2. Transistor à effet de champ à jonction (20) selon la revendication 1, où ladite concentration en porteurs d'un premier type de conductivité dans ladite couche tampon (3) n'est pas supérieure à un dixième de ladite concentration de porteur d'un premier type de conductivité dans ladite couche semi-conductrice d'un premier type de conductivité (1).

3. Transistor à effet de champ à jonction (20) selon la revendication 1, où ladite couche semi-conductrice d'un premier type de conductivité (1) est composée de carbure de silicium.

4. Transistor à effet de champ à jonction (20a) selon la revendication 1, où ladite couche semi-conductrice d'un second type de conductivité (5a, 5b) est formée par implantation d'ions dopant,
le transistor à effet de champ à jonction comprenant en outre une autre couche tampon (18) formée sous ladite région de canal sur ladite couche semi-conductrice d'un second type de conductivité,
une concentration en porteurs d'un premier type de conductivité dans ladite autre couche tampon (18) est inférieure à une concentration en porteurs d'un premier type de conductivité dans ladite couche semi-conductrice d'un premier type de conductivité (1).

5. Transistor à effet de champ à jonction (20a) selon la revendication 4, où ladite concentration en porteurs d'un premier type de conductivité dans ladite autre couche tampon (18) n'est pas supérieure à un dixième de ladite concentration en porteurs d'un premier type de conductivité dans ladite couche semi-conductrice d'un premier type de conductivité (1).

6. Transistor à effet de champ à jonction (20a) selon la revendication 1, comprenant en outre un substrat semi-conducteur (6) composé de carbure de silicium de type n, où
ladite couche semi-conductrice d'un premier type de conductivité (1) est formée sur une surface principale dudit substrat semi-conducteur (6).

7. Transistor à effet de champ à jonction (21) selon la revendication 6, comprenant en outre :
une électrode de grille (11a, 11b) formée sur la surface de ladite région dopée d'un second type de conductivité (4a, 4b),
une électrode (13a, 13b) - soit une électrode de source, soit une électrode de drain - formée sur la surface de ladite couche semi-conductrice d'un premier type de conductivité (1), et
une autre électrode (15) - soit une électrode de drain, soit une électrode de source - formée sur une autre surface principale dudit substrat semi-conducteur (6).
